# EUROPEAN PATENT SPECIFICATION

(11) **EP 3 252 185 B1**
(45) Date of publication and mention of the grant of the patent: **04.11.2020**
(21) Application number: 15880017.7
(22) Date of filing: 30.01.2015
(51) Int. Cl.: C23C 14/50, B23B 27/14, B23P 15/28, C23C 14/32, C23C 14/34, C23C 14/56, C23C 16/458, C23C 16/54

(54) **FILM FORMING DEVICE AND METHOD FOR MANUFACTURING COATED CUTTING TOOL**
FILMBILDENDE VORRICHTUNG UND VERFAHREN ZUR HERSTELLUNG EINES BESCHICHTETEN SCHNEIDWERKZEUGS
DISPOSITIF DE FORMATION DE FILM ET PROCÉDÉ DE FABRICATION D'UN OUTIL DE COUPE REVÊTU

(30) Priority: 26.01.2015 JP 2015012602
(43) Date of publication of application: 06.12.2017
(73) Proprietor: Mitsubishi Materials Corporation, Chiyoda-ku Tokyo 100-8117 (JP)
(72) Inventor: MASUNO Tomoyuki, Joso-shi Ibaraki 300-2795 (JP); SHINBOYA Atsushi, Joso-shi Ibaraki 300-2795 (JP); SUDO Toshikatsu, Joso-shi Ibaraki 300-2795 (JP); KAWAMURA Masao, Joso-shi Ibaraki 300-2795 (JP)
(74) Representative: Hoffmann Eitle
(86) International application number: PCT/JP2015/052763
(87) International publication number: WO 2016/121121

(56) References cited:
- GB-A- 2 133 764
- JP-A- S6 210 267
- JP-A- H06 322 537
- JP-A- H10 140 351
- JP-A- S59 190 359
- JP-A- 2001 254 171
- JP-B1- 5 664 814
- US-A- 5 961 798
- US-B2- 7 625 450

## Description

### Technical Field

The present invention relates to a deposition apparatus and a method for manufacturing a coated cutting tool.

Priority is claimed on Japanese Patent Application No. 2015-012602, filed on January 26, 2015.

### Background Art

A deposition apparatus is known which applies coating to a surface of a cutting tool while rotating the cutting tool (for example, refer to JP H6-322537 A). In an ion plating device described in JP H6-322537 A, an interference member is provided in the vicinity of a path of a carrier frame while a gear-shaped rotating wheel is provided on a table shaft supporting a workpiece. The interference member and the rotating wheel come into contact with each other according to the movement of the carrier frame, and the workpiece is rotated by the rotation of the rotating wheel.

GB 2 133 764 A and US 5 961 798 A are related to the preambles of claims 1 and 7.

### Summary of Invention

### Technical Problem

In a film forming process of a cutting tool, coating is performed while applying a bias voltage to a workpiece. However, if the coating is performed while applying the bias voltage to the carrier frame in the ion plating device described in JP H6-322537 A, it has been found that the bias voltage is irregularly changed during the movement of the carrier frame. If the bias voltage is changed during the coating, there is a concern that a coating film having a desired film quality cannot be obtained.

An object of the present invention is to provide a deposition apparatus capable of forming a coating film having a high quality by stably holding a bias voltage when coating is performed while a workpiece is rotated.

Another object of the present invention is to provide a method for manufacturing a cutting tool including a coating film having a high quality.

### Solution to Problem

According to an aspect of the present invention, there is provided a deposition apparatus, including: a deposition chamber which includes a deposition region for forming a coating film on an object to be coated; a conveying device which conveys a conveyed carrier supporting the object to be coated; and a bias power source which applies a bias voltage to the object to be coated via the conveyed carrier, in which the coating film is formed by allowing the conveyed carrier to pass through the deposition region while applying a bias voltage to the object to be coated, a plurality of rods which support the object to be coated and rotate around axes are disposed in the conveyed carrier along a carrier conveying direction in an upright posture, a protrusion member protruding to the outside in a radial direction is provided on an outer peripheral surface of the rod, an interference member which catches the protrusion member of the conveyed carrier moving in the deposition chamber and rotates the rod around the axis is provided on a wall surface of the deposition chamber via an insulation member, and the interference member and the bias power source are electrically connected to each other, wherein the deposition chamber includes a heating region which is disposed to be adjacent to the deposition region in the carrier conveying direction and heats the object to be coated before the object to be coated enters the deposition region, and a carrier-waiting region which accommodates the conveyed carrier between the deposition region and an end portion of the deposition chamber.

According to this configuration, since the interference member and the protrusion member of the conveyed carrier can be maintained at the same potential, it is possible to prevent a voltage of the conveyed carrier from decreasing due to spark generated when the interference member and the protrusion member come into contact with each other. Therefore, it is possible to form a coating film having a high quality.

The conveying device may include a plurality of conveying rollers disposed along a conveying direction of the conveyed carrier, and the interference member and the bias power source may be electrically connected to each other via one conveying roller or the plurality of conveying rollers.

The interference member may be provided at a position where the interference member rotates the rod passing through the deposition region.

The interference member may rotate the rod at a center portion of the deposition region in the carrier conveying direction.

A plurality of protrusion members may be provided at equal intervals in circumferential directions of the rods.

The deposition chamber includes a heating region which is disposed to be adjacent to the deposition region in the carrier conveying direction and heats the object to be coated before the object to be coated enters the deposition region, and a carrier-waiting region which accommodates the conveyed carrier between the deposition region and an end portion of the deposition chamber.

The heating regions may be provided on both sides of the deposition region in the carrier conveying direction.

According to another aspect of the present invention, there is provided a method for manufacturing a coated cutting tool, using a deposition apparatus including a deposition chamber which forms a coating film on an object to be coated, a conveying device which conveys a conveyed carrier supporting the object to be coated, and a bias power source which applies a bias voltage to the object to be coated via the conveyed carrier, in which a plurality of rods which support the object to be coated and rotate around axes are disposed in the conveyed carrier along a carrier conveying direction in an upright posture, a protrusion member protruding to the outside in a radial direction is provided on an outer peripheral surface of the rod, and an interference member which catches the protrusion member and rotates the rod around the axis is provided on a wall surface of the deposition chamber, the method including: a process of mounting the cutting tool on the conveyed carrier; a process of conveying the conveyed carrier into the deposition chamber and allowing the conveyed carrier to pass through the deposition region; and a process of allowing the interference member and the protrusion member to interfere with each other and to rotate the rod in a state where the bias voltage is applied to the cutting tool and the interference member, wherein the conveyed carrier is conveyed into the deposition chamber and is sequentially passed through a heating region heating the cutting tool and the deposition region.

According to this method, since the interference member and the protrusion member of the conveyed carrier can be maintained at the same potential, it is possible to prevent a voltage of the conveyed carrier from decreasing due to spark generated when the interference member and the protrusion member come into contact with each other. Therefore, it is possible to manufacture a cutting tool including a coating film having a high quality.

In the manufacturing method, the rod may be rotated while passing through the deposition region.

In the manufacturing method, the rod may be rotated at the center portion of the deposition region in the carrier conveying direction.

In the manufacturing method, the conveyed carrier is conveyed into the deposition chamber and is sequentially passed through a heating region heating the cutting tool and the deposition region.

In the manufacturing method, the heating region may be disposed on both sides in a conveying direction of the conveyed carrier with respect to the deposition region, and a plurality of layers of coating films may be formed on the cutting tool by reciprocating the conveyed carrier with respect to a region including a plurality of heating regions and deposition regions.

### Advantageous Effects of Invention

According to the present invention, it is possible to stably apply a bias voltage to a workpiece, and the deposition apparatus which can form a coating film having a high quality is provided.

According to the present invention, the method for manufacturing the cutting tool including the coating film having a high quality is provided.

### Brief Description of Drawings

FIG. 1 is a side view showing an internal structure of a deposition apparatus according to an embodiment.
FIG. 2 is a top view showing the internal structure of the deposition apparatus according to the embodiment.
FIG. 3 is a side view showing a structure of a conveyed carrier.
FIG. 4 is a view showing a support aspect of a cutting tool W.
FIG. 5 is a partial sectional view showing a deposition chamber for explaining a rotation mechanism and a bias voltage applying mechanism.
FIG. 6 is a top view of the deposition chamber for explaining a rotation operation.
FIG. 7 is a graph showing a change of a bias voltage of the conveyed carrier in the deposition apparatus of the embodiment.
FIG. 8 is a graph showing the change of the bias voltage in the conveyed carrier in a configuration in which an arm member and a bias power source are not connected to each other.

### Description of Embodiments

Hereinafter, a deposition apparatus and a method for manufacturing a cutting tool according to an embodiment will be described with reference to the drawings.

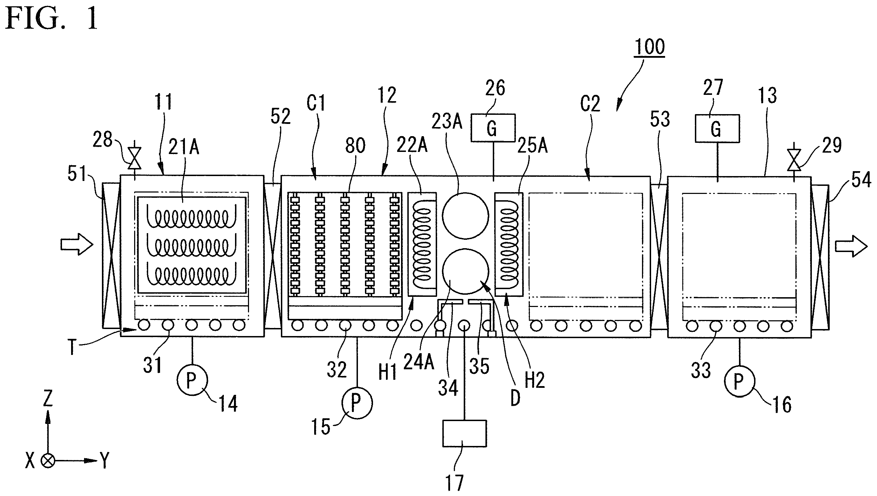

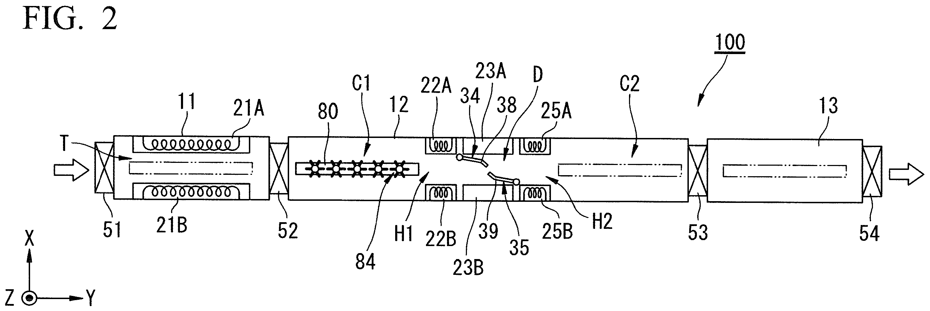

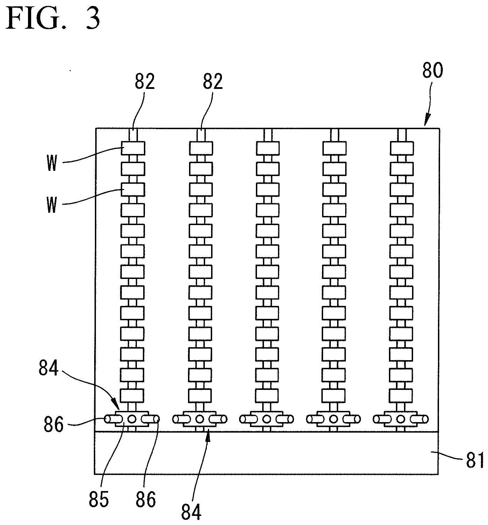

FIG. 1 is a side view showing an internal structure of a deposition apparatus according to an embodiment. FIG. 2 is a top view showing the internal structure of the deposition apparatus according to the embodiment. FIG. 3 is a side view showing a structure of a conveyed carrier.

A deposition apparatus 100 of the present embodiment shown in FIGS. 1 and 2 is an in-line deposition apparatus which performs film forming processing on a cutting tool W while conveying a conveyed carrier 80 on which the cutting tool W are mounted.

As shown in FIG.3, the conveyed carrier 80 includes a rectangular frame 81 and a plurality of (five in the shown example) rods 82 which are disposed inside the frame 81 in an upright posture. Cutting tools W which are objects to which a coating film (a coating film for a cutting tool) is to be formed are inserted into each rod 82 so as to be supported.

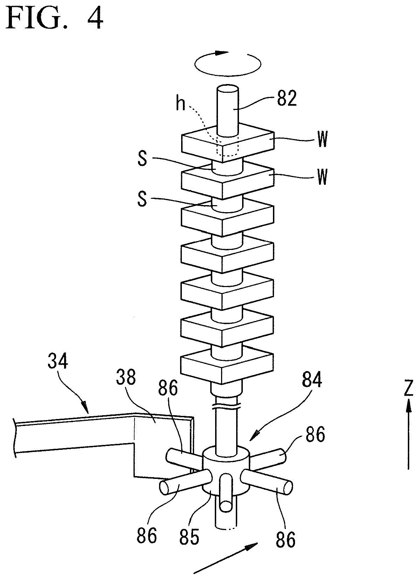

Here, FIG. 4 is a view showing a support aspect of the cutting tools W. The plurality of cutting tools W are disposed in the rod 82 in a state where cylindrical spacers S are interposed between the cutting tools W adjacent to each other. The rod 82 is rotatable around the axis. A rotation mechanism 84 for rotating the rod 82 is provided on the lower portion of the rod 82. The rotation mechanism 84 includes a cylindrical support portion 85 which is fixed to the rod 82, and six protrusion members 86 which are provided on an outer peripheral surface of the support portion 85 at equal intervals in a circumferential direction. All of the protrusion members 86 extend from the support portion 85 in the radial direction of the rod 82 and are orthogonal to the rod 82. Accordingly, in the present embodiment, it is possible to rotate the cutting tools W at a pitch of approximately 60°.

The number or the disposition angle of the protrusion members 86 can be appropriately changed according to the rotation aspects of the cutting tools W. For example, the installation number of the protrusion members 86 may be four or eight, and the plurality of protrusion members 86 may be disposed at irregular intervals in the circumferential direction of the rod 82.

In the present embodiment, the cutting tool W is a cutting insert which is used in a cutting edge-replaceable cutting tool. The cutting insert is a polygonal plate-shaped member which is formed of a hard material such as cemented carbide and a circular attachment hole for attaching the cutting insert to a cutting tool body is formed in the cutting insert. As shown in FIG. 3, in the present embodiment, the rod 82 is inserted into attachment holes h of the cutting tools W.

As shown in FIGS. 1 and 2, the deposition apparatus 100 includes a pre-treatment chamber 11, a deposition chamber 12, and a post-treatment chamber 13. The pre-treatment chamber 11 and the deposition chamber 12 connected to each other via a vacuum valve 52, and the deposition chamber 12 and the post-treatment chamber 13 are connected to each other via a vacuum valve 53. An entrance-side gate valve 51 for introducing the conveyed carrier 80 into the deposition apparatus 100 is provided in the pre-treatment chamber 11. An outlet side gate valve 54 for discharging the conveyed carrier 80 is provided in the post-treatment chamber 13.

Roller conveyors (conveying devices) 31 to 33 in which a plurality of conveying rollers are juxtaposed are laid on the bottom portion sides of the pre-treatment chamber 11, the deposition chamber 12, and the post-treatment chamber 13. The conveyed carrier 80 is conveyed on the roller conveyors 31 to 33. In the present embodiment, a path of the conveyed carrier 80 on the roller conveyors 31 to 33 configure a linear carrier conveying line T. The conveyed carrier 80 on which the cutting tools W are mounted is sequentially conveyed to the pre-treatment chamber 11, the deposition chamber 12, and the post-treatment chamber 13 along the carrier conveying line T.

A vacuum pump 14 and an air-releasing valve 28 are connected to the pre-treatment chamber 11. A heater 21A and a heater 21B for heating the cutting tools W for each conveyed carrier 80 are provided inside the pre-treatment chamber 11. In the case of the present embodiment, the cutting tools W are heated from both sides of the conveyed carrier 80 by the heaters 21A and 21B. Each of the heaters 21A and 21B has a width which is approximately the same as a length of the conveyed carrier 80 in a carrier conveying direction (Y direction in the drawings). In addition, each of the heaters 21A and 21B has a height which is approximately the same as the height of the region within which the cutting tools W of the conveyed carrier 80 are held in a vertical direction (Z direction in the drawings). That is, the heaters 21A and 21B can simultaneously heat all cutting tools W on the conveyed carrier 80.

A vacuum pump 15, a gas source 26, and a bias power source 17 are connected to the deposition chamber 12. A carrier-waiting region C1, a heating region H1, a deposition region D, a heating region H2, and a carrier-waiting region C2 are disposed inside the deposition chamber 12 along the carrier conveying line T in this order. An interference member 34 and an interference member 35 are installed in the vicinity of the carrier conveying line T in the deposition region D. As shown in FIG. 2, the interference member 34 and the interference member 35 are disposed on sides opposite to each other in a state where the carrier conveying line T is interposed therebetween.

In the present specification, the "deposition region" indicates a region inside the deposition chamber having a function for forming a single coating film layer on the surface of the cutting tool W. Accordingly, even in a case where the number of targets or the disposition state of the targets is changed, if a single coating film layer is formed on the surface of the cutting tool W, the region is not determined by the targets, and the region becomes one "deposition region". For example, in the deposition region D, a plurality of targets of the same kind may be disposed to be arranged in the carrier conveying direction (Y direction).

The carrier-waiting region C1 is a region in which the conveyed carrier 80 is temporarily stopped before the heating region H1. The carrier-waiting region C2 is a region in which the conveyed carrier 80 is temporarily stopped after the heating region H2. In addition, the carrier-waiting regions C1 and C2 are regions in which the conveyed carrier 80 is temporarily stopped after the formation of the coating film.

The carrier-waiting region C1 is formed to have a length capable of accommodating the conveyed carrier 80 between the vacuum valve 52 and the deposition region D. Preferably, the carrier-waiting region C1 is formed to have a length capable of accommodating the conveyed carrier 80 between the vacuum valve 52 and the heating region H1.

The carrier-waiting region C2 is formed to have a length capable of accommodating the conveyed carrier 80 between the deposition region D and the vacuum valve 53. Preferably, the carrier-waiting region C2 is formed to have a length capable of accommodating the conveyed carrier 80 between the heating region H2 and the vacuum valve 53.

The heating regions H1 and H2 are regions in which the cutting tools W are heated immediately before the deposition region D. As shown in FIG. 2, in the heating region HI, a heater (heating device) 22A and a heater (heating device) 22B are provided such that the carrier conveying line T is interposed therebetween. The heaters 22A and 22B heat the conveyed carrier 80 which is conveyed from the carrier-waiting region C1 to the deposition region D.

In the heating region H2, a heater (heating device) 25A and a heater (heating device) 25B are provided such that the carrier conveying line T is interposed therebetween. The heaters 25A and 25B heat the conveyed carrier 80 which is conveyed from the carrier-waiting region C2 to the deposition region D.

In the case of the present embodiment, the cutting tools W are heated by allowing the conveyed carrier 80 to pass through a portion between the heaters 22A and 22B or a portion between the heaters 25A and 25B. Accordingly, a width of each of the heaters 22A, 22B, 25A, and 25B in the carrier conveying direction (Y direction) is shorter than the length (the length in the Y direction) of the conveyed carrier 80. The height (the length in the Z direction) of each of the heaters 22A, 22B, 25A, and 25B is a height which is approximately the same as the height of the region within which the cutting tools W of the conveyed carrier 80 are held.

The deposition region D is a region in which coating is performed on the cutting tools W by arc ion plating method. In the case of the present embodiment, four targets are disposed in the deposition region D. As shown in FIG. 2, a pair of targets 23A and 23B are disposed to face each other in a state where the carrier conveying line T is interposed therebetween. As shown in FIG. 1, a target 24A is disposed below (-Z direction) the target 23A vertically. Although not shown, a target is also disposed to face the target 24A below the target 23B vertically.

In addition, in the present embodiment, the plurality of circular targets are installed to form the deposition region D. However, the shape of the target is not limited to a circular shape. For example, a rectangular target elongated in the upward-downward direction (the Z direction in the drawings) of the deposition chamber 12 may be used. In addition, three or more targets may be disposed to be arranged in the upward-downward direction of the deposition chamber 12.

An arc power source (not shown) which supplies arc discharge power to the targets (23A, 23B, and 24A) is provided in the deposition region D. The bias power source 17 applies a bias voltage to the cutting tools W via the conveyed carrier 80 when the conveyed carrier 80 is positioned at least at the deposition region D.

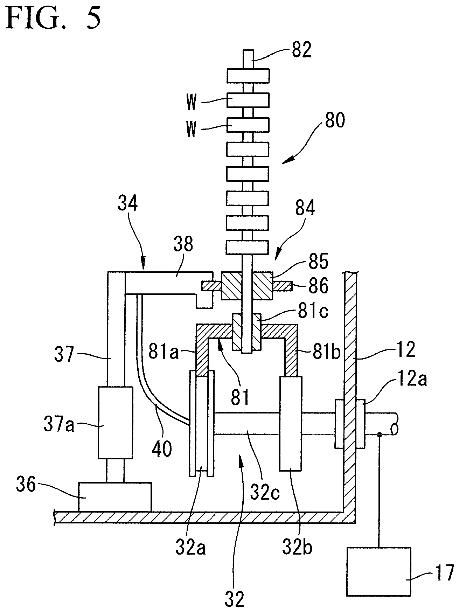

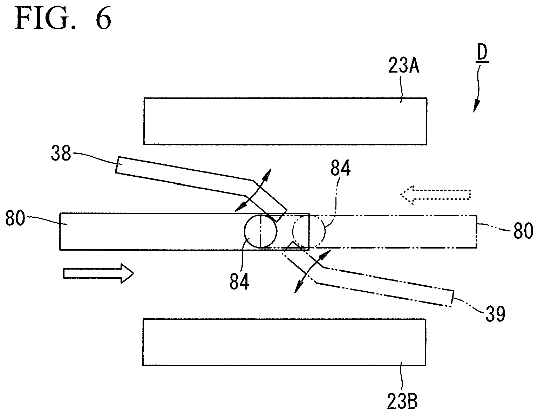

FIG. 5 is a partial sectional view showing the deposition chamber 12 for explaining the rotation mechanism and a bias voltage applying mechanism. FIG. 6 is a top view of the deposition region D for explaining the rotation mechanism.

As shown in FIG. 5, a roller conveyor 32 for conveying the conveyed carrier 80 is provided on the bottom portion of the deposition chamber 12. In the case of the present embodiment, the roller conveyor 32 includes two conveying rollers 32a and 32b, and a shaft 32c which coaxially supports the conveying rollers 32a and 32b. The shaft 32c penetrates the side wall of the deposition chamber 12 to extend to the outside of the deposition chamber 12. A hermetic sealing member 12a is provided at the position where the shaft 32c penetrates the deposition chamber 12 and airtightly seals the outer periphery of the shaft 32c. The bias power source 17 is connected to the shaft 32c which protrudes toward the outside of the deposition chamber 12.

The frame 81 of the conveyed carrier 80 includes two legs 81a and 81b extending downward. The rod 82 is supported by the frame 81 via a bearing 81c. The conveyed carrier 80 is conveyed by the roller conveyor 32 in a state where the leg 81a is supported by the conveying roller 32a and the leg 81b is supported by the conveying roller 32b. In the present embodiment, at least the conveying roller 32a is configured of a conductive member, and the conveying roller 32a is electrically connected to the frame 81 in the leg 81a. Accordingly, the conveyed carrier 80 and the bias power source 17 are electrically connected to each other via the conveying roller 32a and the shaft 32c. All of the frame 81, the bearing 81c, and the rod 82 in the conveyed carrier 80 are configured of conductive members, and the bias voltage supplied from the conveying roller 32a is applied to the cutting tools W through the rod 82.

The interference member 34 stands upright on a bottom wall of the deposition chamber 12 in the vicinity of the roller conveyor 32. The interference member 34 includes an insulation member 36 fixed to the deposition chamber 12, a columnar support member 37 extending upward from the insulation member 36, and an arm member 38 horizontally extending from the upper end of the support member 37. At least the arm member 38 is configured of a conductive member and the arm member 38 is connected to the conveying roller 32a via a cable 40. In the case of the present embodiment, an elastic member 37a is provided in the intermediate portion of the support member 37 in the longitudinal direction. When the support member 37 or the arm member 38 receives impact, for example, when the support member 37 or the arm member 38 collides with the conveyed carrier 80, the elastic member 37a alleviates the impact of the collision to prevent damages of the interference member 34. A rotation drive mechanism (not shown) which rotates the arm member 38 around the axis of the support member 37 is connected to the interference member 34.

The arm member 38 can advance and retreat with respect to the carrier conveying line T. That is, as shown in FIG. 6, the arm member 38 advances and retreats between a position where the arm member 38 does not interfere with the carrier conveying line T and a position where the arm member 38 partially shields the transport path of the rotation mechanism 84 (protrusion member 86). The conveyed carrier 80 enters the center portion (the center portion in the carrier conveying direction) of the deposition region D in a state where the arm member 38 advances into the carrier conveying line T, as shown in FIGS. 4 to 6, the protrusion members 86 of the rotation mechanism 84 come into contact with the arm member 38. If the conveyed carrier 80 further advances therefrom, since the arm member 38 catches the protrusion member 86, the rotation mechanism 84 and the rod 82 rotates around the axis. Accordingly, the cutting tools W supported to the rod 82 rotate.

The interference member 35 has the configuration similar to that of the interference member 34. The interference member 35 has an arm member 39 (FIGS. 2 and 6) which is electrically connected to the bias power source 17. The interference member 35 is disposed in the direction approximately opposite to the interference member 34 in the carrier conveying direction. The arm member 39 of the interference member 35 extends toward the center portion of the deposition region D from the vicinity of a boundary between the heating region H2 and the deposition region D. The interference member 35 rotates the rod 82 of the conveyed carrier 80 entering the deposition region D from the heating region H2 in the center portion of the deposition region D. That is, in the deposition apparatus 100 of the present embodiment, the rod 82 is rotated when the conveyed carrier 80 passes through the center portion of the deposition region D via the heating region H1 from the carrier-waiting region C1 and when the conveyed carrier 80 passes through the center portion of the deposition region D via the heating region H2 from the carrier-waiting region C2, and the cutting tools W are rotated during a film forming period.

Only any one of the interference member 34 and the interference member 35 interferes with the rotation mechanism 84 according to the conveying direction of the conveyed carrier 80. When the conveyed carrier 80 is conveyed from the carrier-waiting region C1 to the deposition region D, only the arm member 38 of the interference member 34 advances into the carrier conveying line T to rotate the rod 82. When the conveyed carrier 80 is conveyed from the carrier-waiting region C2 to the deposition region D, only the arm member 39 of the interference member 35 advances into the carrier conveying line T to rotate the rod 82.

In the present embodiment, the case where only two interference members 34 and 35 are provided is described. However, the number of the installed interference members 34 and 35 is not particularly limited. It is possible to install as many interference members 34 and 35 as necessary to rotate all the rods 82 by the same number of times and the same angle during one film forming period. In addition, the installation positions (rotation position of the rod 82) of the interference members 34 and 35 are not limited to the center portion of the deposition region D, and the interference members 34 and 35 can be installed at arbitrary positions from the carrier-waiting region C1 to the carrier-waiting region C2.

As shown in FIG. 1, a vacuum pump 16, an air-releasing valve 29, and a gas source 27 are connected to the post-treatment chamber 13. The post-treatment chamber 13 is a cooling chamber in which the cutting tools W and the conveyed carrier 80 after the coating are cooled. The gas source 27 supplies gas for cooling a carrier into the post-treatment chamber 13.

Next, a film forming method using the deposition apparatus 100 of the present embodiment will be described.

The deposition apparatus 100 of the present embodiment is suitably used for forming a hard coating film on the surface of a cutting tool.

For example, as the cutting tool which is an object to be coated, there is a cutting insert, a drill, an end mill, a gear cutting tool, or the like. As the material of the cutting tool, high speed steel, cemented carbide, cubic boron nitride, a cermet material, a ceramic material, or the like can be mentioned. For example, as the coating film, TiN, TiAl, TiAIN, TiCN, AlCr, AlCrN, or the like can be mentioned.

In the deposition apparatus 100 of the present embodiment, it is possible to continuously form the coating film on the cutting tools W of the conveyed carrier 80 by reciprocating the conveyed carrier 80 between the carrier-waiting region C1 and the carrier-waiting region C2 to allow the conveyed carrier 80 to pass through the deposition region D a plurality of times.

Hereinafter, this will be described in detail.

First, as shown in FIG. 1, the cutting tools W are mounted on the conveyed carrier 80. In this case, in the deposition apparatus 100, the vacuum valves 52 and 53 are closed, and the pre-treatment chamber 11, the deposition chamber 12, and the post-treatment chamber 13 are held in a predetermined vacuum state (for example, approximately 1 × 10⁻⁵ Pa).

Next, the air-releasing valve 28 of the pre-treatment chamber 11 is open and the inside of the pre-treatment chamber 11 becomes the atmospheric pressure. Thereafter, the entrance-side gate valve 51 is open in the state where the inside of the pre-treatment chamber 11 is the atmospheric pressure, and the conveyed carrier 80 is carried into the pre-treatment chamber 11. The conveyed carrier 80 is stopped at a position where the cutting tools W mounted on the conveyed carrier 80 confront with the heaters 21A and 21B. Thereafter, the entrance-side gate valve 51 is closed. Thereafter, the vacuum pump 14 is operated to evacuate the inside of the pre-treatment chamber 11 until the inside of the pre-treatment chamber 11 reaches a predetermined degree of vacuum (for example, approximately 1 × 10⁻³ Pa)

If the inside of the pre-treatment chamber 11 reaches a predetermined degree of vacuum, the heaters 21A and 21B are operated to heat the cutting tools W and the conveyed carrier 80 to a predetermined temperature. In the present embodiment, the cutting tools W can be uniformly heated from both sides by the heaters 21A and 21B. In this heating, the cutting tools W may be rotated by rotating the rod 82 around the axis.

If the cutting tools W are heated to a predetermined temperature, the vacuum valve 52 is open. Thereafter, the conveyed carrier 80 moves from the pre-treatment chamber 11 to the deposition chamber 12. The conveyed carrier 80 is stopped in the carrier-waiting region C1 inside the deposition chamber 12. After the conveyed carrier 80 is carried in, the vacuum valve 52 is closed. Thereafter, in order to carry the next conveyed carrier 80 into the pre-treatment chamber 11, the air-releasing valve 28 is open and the pre-treatment chamber 11 is returned to the atmospheric pressure. Thereafter, the entrance-side gate valve 51 is open to carry the conveyed carrier 80 into the pre-treatment chamber 11, and the above-described operations are repeated.

Next, in the deposition chamber 12, coating is performed on the cutting tools W.

In the deposition chamber 12, the heaters 22A, 22B, 25A, and 25B are operated in a state where the conveyed carrier 80 is held in the carrier-waiting region C1. Moreover, the deposition region D is set to a state where the film formation with respect to the cutting tools W is possible. Specifically, a predetermined (for example, -300V) bias voltage is applied from the bias power source 17 to the cutting tools W via the frame 81. In this case, in the deposition apparatus 100 of the present embodiment, the bias power source 17, since the arm member 38 of the interference member 34, and the arm member 39 of the interference member 35 are electrically connected to each other, a predetermined bias voltage is also applied to the arm member 38. In addition, a process gas is supplied from the gas source 26 to the deposition chamber 12 and is controlled to a pressure condition (for example, 0.3 to 1 Pa) under which arc discharge is generated on the surfaces of the targets 23A, 23B, and 24A.

Thereafter, the transport of the conveyed carrier 80 to the heating region H1 side starts.

Thereafter, when the conveyed carrier 80 passes through the heating region HI, the cutting tools W are heated by the heaters 22A and 22B. The cutting tools W are heated to a temperature suitable for coating until the cutting tools W pass through the rear end (the end in the +Y direction) of the heating region H1.

Accordingly, the width (the length in the Y direction) of each of the heaters 22A and 22B is set to a length which allows the cutting tools W to be heated to a set temperature at a desired rate of temperature increase while the cutting tools W pass through the heating region H1.

The width of each of the heaters 22A and 22B may be set to any length as long as the heaters can adjust the temperatures of the cutting tools W immediately before the film formation, and if the width is excessively increased, energy consumption increases. In addition, if the widths of the heaters 22A and 22B are excessively increased and the heaters 22A and 22B are too close to the vacuum valve 52, an operation stability of the vacuum valve 52 is likely to be damaged due to heat. Accordingly, from the viewpoint of energy efficiency and a stable operation of the vacuum valve 52, preferably, the width of each of the heaters 22A and 22B is shorter than the width of the conveyed carrier 80 (length in the Y direction).

After the cutting tools W are heated to a predetermined temperature in the heating region HI, the cutting tools W continuously passes through the deposition region D. When the cutting tool W passes through the deposition region D, coating films having a desired composition are formed on the surfaces of the cutting tools W. For example, in a case where a Ti target is used as the target and an N₂ containing gas is used as the process gas, a TiN film is formed on the surfaces of the cutting tools W. The film thickness and the uniformity of the coating film can be controlled by a bias voltage, a gas pressure, a transport speed of the conveyed carrier 80, a rotation angle pitch of the cutting tool W, or the like.

In the present embodiment, when the cutting tools W on the conveyed carrier 80 pass through the center portion of the deposition region D, since the rotation mechanism 84 interferes with the arm member 38, the cutting tools W rotate approximately 60° around the axes and are stopped. In this case, since the bias voltage is also applied to the arm member 38, the arm member 38 and the protrusion members 86 having the same potential come into contact with each other. In the case of the present embodiment, since the cutting tool W rotates by 60° around the axes in the center portion of the deposition region D, the side surfaces of the cutting tool W which are shifted by 60° in a first half and a second half of a period of passing through the deposition region D face the targets. That is, coating is performed on the region of 240° (60° × 2 × 2 surfaces) among the peripheral surface 360° of the cutting tool W while the cutting tool W passes through the deposition region D once.

After the cutting tools W sequentially pass through the deposition region D from the head side of the conveyed carrier 80, the cutting tools W are heated again in the heating region H2, and thereafter, the cutting tools W passes through the heating region H2 and enter the carrier-waiting region C2. In the present embodiment, the conveying direction of the conveyed carrier 80 is reversed at the time point when the cutting tools W mounted on the tail end of the conveyed carrier 80 reaches the center portion of the deposition region D. That is, the conveying direction of the conveyed carrier 80 is changed in a direction from the carrier-waiting region C2 toward the carrier-waiting region C1. In this case, the operation states of the heating regions H1 and H2 and the deposition region D are maintained without being stopped. Accordingly, in the present embodiment, some cutting tools W positioned on the tail side of the conveyed carrier 80 are not heated in the heating region H2.

The turning in the traveling direction of the conveyed carrier 80 may be performed at a position other than the above-described position. For example, the turning may be performed at the time when the tail end of the conveyed carrier 80 comes out from the deposition region D.

If the conveying direction of the conveyed carrier 80 is reversed, continuously, coating films are sequentially laminated from the cutting tools W positioned in the carrier-waiting region C1. That is, coating in the deposition region D is sequentially performed from the cutting tools W positioned on the head side (the end portion on the carrier-waiting region C1 side) in the conveying direction of the conveyed carrier 80. The heating in the heating region H2 and the coating in the deposition region D are performed on the cutting tools W positioned in the carrier-waiting region C2 at the time when the conveyed carrier 80 is reversed, and the rotation operation is performed by the interference between the interference member 35 and the protrusion members 86 during the coating. In the rotation operation in this backward path, in the center portion of the deposition region D, the protrusion members 86 of the rotation mechanism 84 and the arm member 39 of the interference member 35 come into contact with each other, and the rod 82 and the cutting tools W rotate approximately 60° around the axis. In this case, the protrusion members 86 and the arm member 39 having the same potential come into contact with each other.

Thereafter, the conveying direction of the conveyed carrier 80 is reversed again at the time point when the cutting tools W mounted on the tail end (the end portion on the carrier-waiting region C2 side) of the conveyed carrier 80 reaches the center portion of the deposition region D. That is, the conveying direction of the conveyed carrier 80 is changed again in the direction from the carrier-waiting region C2 toward the carrier-waiting region C1.

In this case, the turning in the traveling direction of the conveyed carrier 80 may be performed at the time point when the tail end of the conveyed carrier 80 comes out from the deposition region D.

Thereafter, the coating films are sequentially laminated from the cutting tools W positioned on the carrier-waiting region C2 side. That is, the coating in the deposition region D is sequentially performed from the cutting tools W positioned on the head side (the end portion on the carrier-waiting region C2 side) in the conveying direction of the conveyed carrier 80, and the rotation operation (approximately 60° around the axis) is performed by the interference between the interference member 34 and the protrusion member 86 during the coating. The heating in the heating region H1 and the coating in the deposition region D are sequentially performed on the cutting tools W positioned in the carrier-waiting region C1 or the heating region H1 at the time point when the conveyed carrier 80 is reversed again.

In the present embodiment, the conveyed carrier 80 reciprocates one and a half between the carrier-waiting region C1 and the carrier-waiting region C2 and passes through the deposition region D three times. In addition, since the cutting tool W is rotated by 60° every time the cutting tool W passes through the center of the deposition region D, coating is applied to the peripheral surface of the cutting tool W in a total of 720°. That is, two layers of the coating are uniformly applied to each portion of the cutting tool W.

Thereafter, if the conveyed carrier 80 is accommodated in the carrier-waiting region C2, the coating ends. Specifically, applying of the bias voltage and arc discharge with respect to the cutting tools W are stopped.

Next, the vacuum valve 53 between the deposition chamber 12 and the post-treatment chamber 13 is open, and the conveyed carrier 80 is fed out to the post-treatment chamber 13. If the conveyed carrier 80 is carried into the post-treatment chamber 13, the vacuum valve 53 is closed. An operation of opening the vacuum valve 52 between the pre-treatment chamber 11 and the deposition chamber 12 and carrying the next conveyed carrier 80 into the deposition chamber 12 may be performed together with this transport operation.

In the post-treatment chamber 13, the conveyed carrier 80 carried from the deposition chamber 12 into the post-treatment chamber 13 is stopped in the post-treatment chamber 13 to be cooled. The cooling is performed by maintaining a pressure during a predetermined time while supplying a cooling gas from the gas source 27 into the post-treatment chamber 13. As the cooling gas, an inert gas can be used.

If the cooling is completed, the air-releasing valve 29 is open and the pressure inside the post-treatment chamber 13 is returned to the atmospheric pressure. Thereafter, the outlet side gate valve 54 is open and the conveyed carrier 80 is carried out from the post-treatment chamber 13. After the conveyed carrier 80 is carried out, an evacuation operation in the post-treatment chamber 13 is performed by the vacuum pump 16. Thereafter, a predetermined degree of vacuum (for example, 1 × 10⁻³ Pa) is maintained in the post-treatment chamber 13 until the next conveyed carrier 80 is carried into the post-treatment chamber 13.

One conveyed carrier 80 can be accommodated in each of the pre-treatment chamber 11, the deposition chamber 12, and the post-treatment chamber 13 of the deposition apparatus 100 of the present embodiment. In this state, the heating in the pre-treatment chamber 11, the coating in the deposition chamber 12, and the cooling in the post-treatment chamber 13 can be performed together. In this way, it is possible to effectively perform the coating on the cutting tools W by repeating the transport of the conveyed carrier 80, and the heating, the coating, and the cooling in each chamber.

In the above description, the case where the direction of the conveyed carrier 80 is switched twice and the conveyed carrier 80 passes through the deposition region D three times is described. However, the reciprocation of the conveyed carrier 80 can be repeated as many times as necessary. In addition, the number of film formations on the surface of the cutting tool W may be adjusted to be uniform by changing the number (the rotation pitch) of the protrusion members 86 according to the number of times of the reciprocations.

According to the deposition apparatus 100 of the above-described present embodiment, it is possible to transport the conveyed carrier 80 while rotating the cutting tools W on the conveyed carrier 80. Accordingly, it is possible to continuously perform the heating and the film forming processing of the coating film with respect to the cutting tools W while switching the side surfaces of the cutting tools W facing the targets (23A, 23B, and 24A) by reciprocating the conveyed carrier 80 between the carrier-waiting regions C1 and C2. In the present embodiment, the cutting tool W rotates by a predetermined angle at least once during the formation of the coating film, it is possible to more uniformly form the coating film.

In the present embodiment, the arm members 38 and 39 and the bias power source 17 are electrically connected to each other. Accordingly, since the arm members 38 and 39 and the protrusion members 86 of the conveyed carrier 80 can be maintained at the same potential, it is possible to prevent a voltage of the conveyed carrier 80 from decreasing due to spark generated when the arm member 38 or the arm member 39 comes into contact with the protrusion members 86.

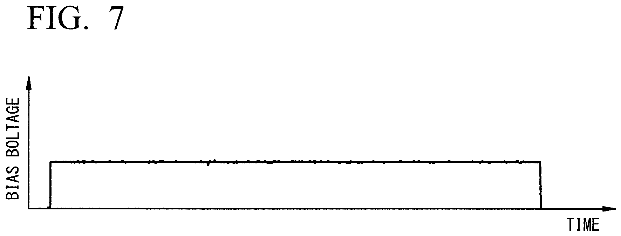

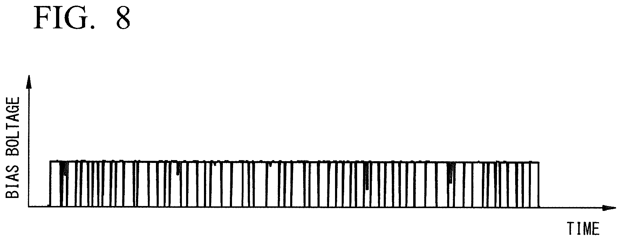

Here, FIG. 7 is a graph showing a change of a bias voltage of the conveyed carrier 80 in the deposition apparatus 100 of the present embodiment. FIG. 8 is a graph showing the change of the bias voltage in the conveyed carrier 80 in a configuration in which the arm members 38 and 39 and the bias power source 17 are not connected to each other.

As is apparent from the comparison between FIG. 7 and FIG. 8, in the deposition apparatus 100 of the present embodiment, the bias voltage of the conveyed carrier 80 can be approximately constantly maintained during the film forming period. However, in the case where the arm members 38 and 39 and the bias power source 17 are not connected to each other, the bias voltage is abruptly changed and is greatly changed between the applied voltage (maximum value) and approximately 0 V. This is because spark is generated between the arm members 38 and 39 and the protrusion members 86 at the moment when the arm members 38 and 39 and the protrusion members 86 come into contact with each other and the charge on the conveyed carrier 80 side is released.

In the present embodiment, as shown in FIG. 6, the interference members 34 and 35 and the rotation mechanism 84 interfere with each other at the center portion of the deposition region D. If a decrease in the bias voltage is generated by spark due to the conditions, it is not possible to form a coating film having a desired film quality on the surfaces of the cutting tools W.

In contrast, in the deposition apparatus 100 of the present embodiment, since the arm members 38 and 39 and the protrusion members 86 have the same potential, it is possible to prevent the spark generated when the arm members 38 and 39 and the protrusion members 86 come into contact with each other. As a result, as shown in FIG. 7, since the bias voltage is maintained constantly, it is possible to stably form the coating film having a desired film quality on the surfaces of the cutting tools W. Therefore, according to the deposition apparatus 100 of the present embodiment, it is possible to form the coating film having a high quality.

Even in a configuration in which the rod 82 rotates at the position separated from the deposition region D, since the plurality of rods 82 are provided on the conveyed carrier 80, the rod 82 positioned closer to the head side than the rod 82 may be positioned in the deposition region D at the moment when one rod 82 rotates. Accordingly, even in a case where the rod 82 rotates outside the deposition region D, there is a concern that the bias voltages of the cutting tools W during the film formation are changed. Accordingly, like the present embodiment, preferably, the bias voltage is applied to the arm members 38 and 39.

In addition, according to the deposition apparatus 100 of the present embodiment, since the heating regions H1 and H2 are provided on both sides (-Y direction side and +Y direction side in the drawings) of the deposition region D of the deposition chamber 12 in the carrier conveying direction, it is possible to heat the cutting tools W to a predetermined temperature immediately before the film is formed. Accordingly, it is possible to adjust the cutting tools W of all conveyed carriers 80 to a constant temperature immediately before the coating is performed.

In a case where the heating region H1 is not provided in the deposition chamber 12, the temperature of the cutting tools W on the conveyed carrier 80 is approximately constant immediately after the cutting tools W are heated in the pre-treatment chamber 11. However, it takes times until the cutting tools W on the head side of the conveyed carrier 80 and the cutting tools W on the tail side enter the deposition region D after the cutting tools W are heated. Accordingly, differences are generated between the film formation temperatures of the cutting tools on the head side of the conveyed carrier 80 and the film formation temperatures of the cutting tools W on the tail side, and the differences are likely to influence the film quality of the coating film.

In contrast, in the deposition apparatus 100 of the present embodiment, all the cutting tools can always enter the deposition region D at a constant temperature by heating in the heating region H1. Accordingly, since the coating can be performed under a constant temperature condition, it is possible to prevent the quality of the coating film for each cutting tool W from being dispersed and form the coating film with a high yield.

In addition, in the case where the heating region H1 is not provided in the deposition chamber 12, the temperature is low when the film formation starts, and the temperature of the cutting tool W is suddenly increased due to heat generation generated by the arc discharge or the bias application in the deposition region D. Accordingly, since the coating film is formed under a low temperature condition at the beginning of the film formation, there is a concern that the coating film having low adhesion or a low film quality is formed.

In contrast, in the present embodiment, the coating can be performed at an optimum temperature from the beginning of the film formation to the end thereof, and it is possible to form the coating film having a high quality.

In addition, in the present embodiment, the plurality of rods 82 of the conveyed carrier 80 are arranged in the upright posture along the carrier conveying direction, and the cutting tools W are supported by the rods 82. Accordingly, the distances between the cutting tools W passing through the deposition region D and the targets (23A, 23B, and 24A) are approximately constantly held. Accordingly, not only the film formation temperature of each cutting tool W but also other film formation conditions are constant. Accordingly, it is possible to more uniformly form the coating film in the film thickness direction.

### Industrial Applicability

According to the present invention, it is possible to stably apply a bias voltage to a workpiece, and the deposition apparatus which can form a coating film having a high quality is provided.

According to the present invention, the method for manufacturing the cutting tool including the coating film having a high quality is provided.

Accordingly, the present invention has industrial applicability.

### Reference Signs List

12: deposition chamber, 17: bias power source, 32a, 32b: conveying roller, 34, 35: interference member, 36: insulation member, 38, 39: arm member, 80: conveyed carrier, 82: rod, 86: protrusion member, 100: deposition apparatus, 31: roller conveyor (conveying device), D: deposition region, W: cutting tool, C1, C2: carrier-waiting region, HI, H2: heating region

## Claims

1. A deposition apparatus, comprising:
a deposition chamber (12) which includes a deposition region (D) for forming a coating film on an object to be coated;
a conveying device (31) which conveys a conveyed carrier (80) supporting the object to be coated; and
a bias power source (17) which applies a bias voltage to the object to be coated via the conveyed carrier (80),
wherein the coating film is formed by allowing the conveyed carrier (80) to pass through the deposition region (D) while applying a bias voltage to the object to be coated,
wherein a plurality of rods (82) which support the object to be coated and rotate around axes are disposed in the conveyed carrier (80) along a carrier conveying direction in an upright posture,
wherein a protrusion member (86) protruding to the outside in a radial direction is provided on an outer peripheral surface of the rod (82),
wherein an interference member (34, 35) which catches the protrusion member (86) of the conveyed carrier (80) moving in the deposition chamber (12) and rotates the rod (82) around the axis is provided on a wall surface of the deposition chamber (12) via an insulation member (36), and
wherein the interference member (34, 35) and the bias power source (17) are electrically connected to each other,
**characterized in that** the deposition chamber (12) includes a heating region (H1, H2) which is disposed to be adjacent to the deposition region (D) in the carrier conveying direction and heats the object to be coated before the object to be coated enters the deposition region (D), and a carrier-waiting region (C1, C2) which accommodates the conveyed carrier (80) between the deposition region (D) and an end portion of the deposition chamber (12).

2. The deposition apparatus according to claim 1,
wherein the conveying device (31) includes a plurality of conveying rollers (32a, 32b) disposed along a conveying direction of the conveyed carrier (80), and
wherein the interference member (34, 35) and the bias power source (17) are electrically connected to each other via one conveying roller (32a, 32b) or the plurality of conveying rollers (32a, 32b).

3. The deposition apparatus according to claim 1 or 2,
wherein the interference member (34, 35) is provided at a position where the interference member (34, 35) rotates the rod (82) passing through the deposition region (D).

4. The deposition apparatus according to claim 3,
wherein the interference member (34, 35) rotates the rod (82) at a center portion of the deposition region (D) in the carrier conveying direction.

5. The deposition apparatus according to any one of claims 1 to 4,
wherein a plurality of protrusion members (86) are provided at equal intervals in circumferential directions of the rods (82).

6. The deposition apparatus according to claim 1,
wherein the heating regions (H1, H2) are provided on both sides of the deposition region (D) in the carrier conveying direction.

7. A method for manufacturing a coated cutting tool (W), using a deposition apparatus including a deposition chamber (12) which forms a coating film on an object to be coated, a conveying device (31) which conveys a conveyed carrier (80) supporting the object to be coated, and a bias power source (17) which applies a bias voltage to the object to be coated via the conveyed carrier (80), in which a plurality of rods (82) which support the object to be coated and rotate around axes are disposed in the conveyed carrier (80) along a carrier conveying direction in an upright posture, a protrusion member (86) protruding to the outside in a radial direction is provided on an outer peripheral surface of the rod (82), and an interference member (34, 35) which catches the protrusion member (86) and rotates the rod (82) around the axis is provided on a wall surface of the deposition chamber (12),
the method comprising the steps of:
mounting the coated cutting tool (W) on the conveyed carrier (80);
conveying the conveyed carrier (80) into the deposition chamber (12) and allowing the conveyed carrier (80) to pass through the deposition region (D); and
allowing the interference member (34, 35) and the protrusion member (86) to interfere with each other and to rotate the rod (82) in a state where the bias voltage is applied to the coated cutting tool (W) and the interference member (34, 35),
**characterized in that** the conveyed carrier (80) is conveyed into the deposition chamber (12) and is sequentially passed through a heating region (H1, H2) heating the coated cutting tool (W) and the deposition region (D).

8. The method for manufacturing a coated cutting tool (W) according to claim 7,
wherein the rod (82) is rotated while passing through the deposition region (D).

9. The method for manufacturing a coated cutting tool (W) according to claim 8,
wherein the rod (82) is rotated at the center portion of the deposition region (D) in the carrier conveying direction.

10. The method for manufacturing a coated cutting tool (W) according to claim 7,
wherein the heating region (H1, H2) are disposed on both sides in a conveying direction of the conveyed carrier (80) with respect to the deposition region (D), and a plurality of layers of coating films are formed on the coated cutting tool (W) by reciprocating the conveyed carrier (80) with respect to a region including a plurality of heating regions (H1, H2) and deposition regions (D).

## Patentansprüche

1. Abscheidungseinrichtung, umfassend:
eine Abscheidungskammer (12), die einen Abscheidungsbereich (D) zum Bilden eines Beschichtungsfilms auf einem zu beschichtenden Objekt einschließt;
eine Fördervorrichtung (31), die einen Förderträger (80) befördert, der das zu beschichtende Objekt stützt; und
eine Vorspannungsleistungsquelle (17), die eine Vorspannung an das zu beschichtende Objekt über den beförderten Träger (80) anlegt,
wobei der Beschichtungsfilm durch Durchlassen des beförderten Trägers (80) durch den Abscheidungsbereich (D) gebildet wird, während eine Vorspannung an das zu beschichtende Objekt angelegt wird,
wobei eine Vielzahl von Stäben (82), die das zu beschichtende Objekt stützen und sich um Achsen drehen, in dem beförderten Träger (80) entlang einer Trägerförderrichtung in aufrechter Haltung angeordnet sind,
wobei ein in radialer Richtung nach außen vorstehendes Vorsprungselement (86) an einer äußeren Umfangsfläche des Stabs (82) bereitgestellt ist,
wobei ein Interferenzelement (34, 35), das das Vorsprungselement (86) des sich in der Abscheidungskammer (12) bewegenden Förderträgers (80) auffängt und den Stab (82) um die Achse dreht, an einer Wandfläche der Abscheidekammer (12) über ein Isolierelement (36) bereitgestellt ist, und
wobei das Interferenzelement (34, 35) und die Vorspannungsleistungsquelle (17) elektrisch miteinander verbunden sind,
**dadurch gekennzeichnet, dass** die Abscheidungskammer (12) einen Erwärmungsbereich (H1, H2), der so angeordnet ist, dass er in Trägerträgerrichtung benachbart zum Abscheidungsbereich (D) liegt und das zu beschichtende Objekt erwärmt, bevor das zu beschichtende Objekt in den Abscheidungsbereich (D) eintritt, und einen Trägerwartebereich (C1, C2) einschließt, der den beförderten Träger (80) zwischen dem Abscheidungsbereich (D) und einem Endabschnitt der Abscheidungskammer (12) aufnimmt.

2. Abscheidungseinrichtung nach Anspruch 1,
wobei die Fördervorrichtung (31) eine Vielzahl von Förderrollen (32a, 32b) einschließt, die entlang einer Förderrichtung des Förderträgers (80) angeordnet sind, und
wobei das Interferenzelement (34, 35) und die Vorspannungsleistungsquelle (17) über eine Förderrolle (32a, 32b) oder die Vielzahl von Förderrollen (32a, 32b) elektrisch miteinander verbunden sind.

3. Abscheidungseinrichtung nach Anspruch 1 oder 2,
wobei das Interferenzelement (34, 35) an einer Position bereitgestellt ist, an der das Interferenzelement (34, 35) den Stab (82) dreht, der durch den Abscheidungsbereich (D) verläuft.

4. Abscheidungseinrichtung nach Anspruch 3,
wobei das Interferenzelement (34, 35) den Stab (82) an einem Mittelabschnitt des Abscheidungsbereichs (D) in der Trägerförderrichtung dreht.

5. Abscheidungseinrichtung nach einem der Ansprüche 1 bis 4,
wobei eine Vielzahl von Vorsprungselementen (86) in gleichen Abständen in Umfangsrichtungen der Stäbe (82) bereitgestellt ist.

6. Abscheidungseinrichtung nach Anspruch 1,
wobei die Erwärmungsbereiche (H1, H2) auf beiden Seiten des Abscheidungsbereichs (D) in der Trägerförderrichtung bereitgestellt sind.

7. Verfahren zum Herstellen eines beschichteten Schneidwerkzeugs (W) unter Verwendung einer Abscheidungseinrichtung mit einer Abscheidungskammer (12), die einen Beschichtungsfilm auf einem zu beschichtenden Objekt bildet, einer Fördervorrichtung (31), die einen beförderten Träger (80) befördert, der das zu beschichtende Objekt stützt, und eine Vorspannungsleistungsquelle (17), die eine Vorspannung an das zu beschichtende Objekt anlegt, über den beförderten Träger (80), in dem eine Vielzahl von Stäben (82), die das zu beschichtende Objekt stützen und um Achsen drehen, in dem beförderten Träger (80) entlang einer Trägerförderrichtung in aufrechter Haltung angeordnet sind, wobei ein in radialer Richtung nach außen vorstehendes Vorsprungselement (86) an einer äußeren Umfangsfläche des Stabs (82) bereitgestellt ist; und ein Interferenzelement (34, 35), das das Vorsprungselement (86) auffängt und den Stab (82) um die Achse dreht, an einer Wandfläche der Abscheidungskammer (12) bereitgestellt ist
wobei das Verfahren die folgenden Schritte umfasst:
Anbringen des beschichteten Schneidwerkzeugs (W) an dem beförderten Träger (80);
Befördern des beförderten Trägers (80) in die Abscheidungskammer (12) und Durchlassen des beförderten Trägers (80) durch den Abscheidungsbereich (D); und
Ermöglichen, dass das Interferenzelement (34, 35) und das Vorsprungselement (86) sich gegenseitig beeinflussen und den Stab (82) in einem Zustand drehen, in dem die Vorspannung an das beschichtete Schneidwerkzeug (W) und das Interferenzelement (34, 35) angelegt wird,
**dadurch gekennzeichnet, dass** der beförderte Träger (80) in die Abscheidungskammer (12) befördert wird und nacheinander durch einen Erwärmungsbereich (H1, H2) geleitet wird, der das beschichtete Schneidwerkzeug (W) und den Abscheidungsbereich (D) erwärmt.

8. Verfahren zum Herstellen eines beschichteten Schneidwerkzeugs (W) nach Anspruch 7, wobei der Stab (82) gedreht wird, während er durch den Abscheidungsbereich (D) läuft.

9. Verfahren zum Herstellen eines beschichteten Schneidwerkzeugs (W) nach Anspruch 8,
wobei der Stab (82) an dem Mittelabschnitt des Abscheidungsbereichs (D) in der Trägerförderrichtung gedreht wird.

10. Verfahren zum Herstellen eines beschichteten Schneidwerkzeugs (W) nach Anspruch 7,
wobei der Erwärmungsbereich (H1, H2) beidseitig in einer Förderrichtung des beförderten Trägers (80) in Bezug auf den Abscheidungsbereich (D) angeordnet wird und eine Vielzahl von Schichten von Beschichtungsfilmen auf dem beschichteten Schneidwerkzeug (W) durch Hin- und Herbewegen des beförderten Trägers (80) in Bezug auf einen Bereich, der eine Vielzahl von Erwärmungsbereichen (H1, H2) und Abscheidungsbereiche (D) einschließt, gebildet wird.

## Revendications

1. Appareil de dépôt, comprenant :
une chambre de dépôt (12) qui inclut une zone de dépôt (D) pour former un film de revêtement sur un objet à revêtir ;
un dispositif de transport (31) qui transporte un support transporté (80) supportant l'objet à revêtir ; et
une source d'alimentation de polarisation (17) qui applique une tension de polarisation à l'objet à revêtir via le support transporté (80),
dans lequel le film de revêtement est formé en permettant au support transporté (80) de passer à travers la zone de dépôt (D) tout en appliquant une tension de polarisation à l'objet à revêtir,
dans lequel une pluralité de tiges (82) qui supportent l'objet à revêtir et tournent autour d'axes sont disposées dans le support transporté (80) le long d'une direction de transport de support dans une posture verticale,
dans lequel un élément en saillie (86) faisant saillie vers l'extérieur dans une direction radiale est prévu sur une surface périphérique extérieure de la tige (82),
dans lequel un élément d'interférence (34, 35) qui attrape l'élément en saillie (86) du support transporté (80) se déplaçant dans la chambre de dépôt (12) et met en rotation la tige (82) autour de l'axe est prévu sur une surface de paroi de la chambre de dépôt (12) via un élément isolant (36), et
dans lequel l'élément d'interférence (34, 35) et la source d'alimentation de polarisation (17) sont électriquement connectés l'un à l'autre,
**caractérisé en ce que** la chambre de dépôt (12) inclut une zone de chauffage (H1, H2) qui est disposée pour être adjacente à la zone de dépôt (D) dans la direction de transport de support et chauffe l'objet à revêtir que l'objet à revêtir n'entre dans la zone de dépôt (D), et une zone de support en attente (C1, C2) qui reçoit le support transporté (80) entre la zone de dépôt (D) et une partie d'extrémité de la chambre de dépôt (12).

2. Appareil de dépôt selon la revendication 1,
dans lequel le dispositif de transport (31) inclut une pluralité de rouleaux de transport (32a, 32b) disposés le long d'une direction de transport du support transporté (80), et
dans lequel l'élément d'interférence (34, 35) et la source d'alimentation de polarisation (17) sont électriquement connectés l'un à l'autre via un rouleau de transport (32a, 32b) ou la pluralité de rouleaux de transport (32a, 32b).

3. Appareil de dépôt selon la revendication 1 ou 2,
dans lequel l'élément d'interférence (34, 35) est prévu au niveau d'une position où l'élément d'interférence (34, 35) met en rotation la tige (82) en passant à travers la zone de dépôt (D).

4. Appareil de dépôt selon la revendication 3,
dans lequel l'élément d'interférence (34, 35) met en rotation la tige (82) au niveau d'une partie centrale de la zone de dépôt (D) dans la direction de transport de support.

5. Appareil de dépôt selon l'une quelconque des revendications 1 à 4,
dans lequel une pluralité d'éléments en saillie (86) sont prévus à intervalles égaux dans des directions circonférentielles des tiges (82).

6. Appareil de dépôt selon la revendication 1,
dans lequel les zones de chauffage (H1, H2) sont prévues des deux côtés de la zone de dépôt (D) dans la direction de transport de support.

7. Procédé de fabrication d'un outil de coupe revêtu (W), en utilisant un appareil de dépôt incluant une chambre de dépôt (12) qui forme un film de revêtement sur un objet à revêtir, un dispositif de transport (31) qui transporte un support transporté (80) supportant l'objet à revêtir, et une source d'alimentation de polarisation (17) qui applique une tension de polarisation à l'objet à revêtir via le support transporté (80), dans lequel une pluralité de tiges (82) qui supportent l'objet à revêtir et tournent autour d'axes sont disposées dans le support transporté (80) le long d'une direction de transport de support dans une posture verticale, un élément en saillie (86) faisant saillie vers l'extérieur dans une direction radiale est prévu sur une surface périphérique extérieure de la tige (82), et un élément d'interférence (34, 35) qui attrape l'élément en saillie (86) et met en rotation la tige (82) autour de l'axe est prévu sur une surface de paroi de la chambre de dépôt (12),
le procédé comprenant les étapes consistant à :
monter l'outil de coupe revêtu (W) sur le support transporté (80) ;
transporter le support transporté (80) à l'intérieur de la chambre de dépôt (12) et permettre au support transporté (80) de passer à travers la zone de dépôt (D) ; et
permettre à l'élément d'interférence (34, 35) et à l'élément en saillie (86) d'interférer l'un avec l'autre et de mettre en rotation la tige (82) dans un état où la tension de polarisation est appliquée à l'outil de coupe revêtu (W) et à l'élément d'interférence (34, 35),
**caractérisé en ce que** le support transporté (80) est transporté dans la chambre de dépôt (12) et est passé séquentiellement à travers une zone de chauffage (H1, H2) chauffant l'outil de coupe revêtu (W) et la zone de dépôt (D).

8. Procédé de fabrication d'un outil de coupe revêtu (W) selon la revendication 7,
dans lequel la tige (82) est mise en rotation tout en passant à travers la zone de dépôt (D).

9. Procédé de fabrication d'un outil de coupe revêtu (W) selon la revendication 8,
dans lequel la tige (82) est mise en rotation au niveau de la partie centrale de la zone de dépôt (D) dans la direction de transport de support.

10. Procédé de fabrication d'un outil de coupe revêtu (W) selon la revendication 7,
dans lequel les zones de chauffage (H1, H2) sont disposées des deux côtés dans une direction de transport du support transporté (80) par rapport à la zone de dépôt (D), et une pluralité de couches de films de revêtement sont formées sur l'outil de coupe revêtu (W) en mettant en va-et-vient le support transporté (80) par rapport à une zone incluant une pluralité de zones de chauffage (H1, H2) et de zones de dépôt (D).
